# EUROPÄISCHE PATENTSCHRIFT

(11) **EP 1 391 928 B1**
(45) Veröffentlichungstag und Bekanntmachung des Hinweises auf die Patenterteilung: **18.03.2009**
(21) Anmeldenummer: 03017866.9
(22) Anmeldetag: 05.08.2003
(51) Int. Cl.: H01L 23/544, H01L 21/98, H01L 25/065

(54) **Chipanordung mit zumindest zwei Halbleiterchips und Verfahren zur Überprüfung der Ausrichtung zweier benachbarter Halbleiterchips**
Chip assembly with at least two semiconductor chips and method of controlling the alignment of two adjacent semiconductor chips
Assemblage de puces avec au moins deux puces semi-conductrices et méthode de test de l'alignement de deux puces semi-conductrices voisinées

(30) Priorität: 23.08.2002 DE 10238835
(43) Veröffentlichungstag der Anmeldung: 25.02.2004
(73) Patentinhaber: Infineon Technologies AG, 81669 München (DE)
(72) Erfinder: Gruber, Wolfgang, 82140 Olching-Neuesting (DE); Janke, Marcus, 81539 München (DE)
(74) Vertreter: Epping - Hermann - Fischer

(56) Entgegenhaltungen:
- WO-A1-97/024740
- DE-A1- 10 065 747
- US-A- 5 824 571
- US-A- 6 143 621
- US-A1- 2002 104 872
- US-B1- 6 242 757
- US-B1- 6 380 554

## Beschreibung

Die Erfindung betrifft einen Halbleiterchip, eine Chipanordnung mit zumindest zwei Halbleiterchips und ein Verfahren zum Überprüfen der Ausrichtung zweier übereinanderliegender Halbleiterchips in einer derartigen Chipanordnung gemäß der nebengeordneten Patentansprüche.

Insbesondere für elektronischen Zahlungsverkehr, elektronische Authentifizierung und dergleichen besteht in zunehmendem Maße das Bedürfnis, sicher, d. h. nicht manipulierte bzw. nicht manipulierbare Bauelemente zu verwenden. Darunter ist beispielweise zu verstehen, daß Paßwörter, Schlüsselwörter oder desgleichen, die in Bauelementen abgespeichert sind, vor einem Ausspähen zu schützen. Auch soll verhindert werden, daß Verfahrensweisen, die auf den Bauelementen ablaufen manipulierbar sind.

Bei dem Versuch eine solche Manipulation durchzuführen, kommt es häufig vor, daß das Bauelement beschädigt wird und durch ein neues, ungeschütztes Bauelement ersetzt wird, bzw. nach der Manipulation für den Betrieb repariert wird. Als Schutz hiergegen ist es bereits bekannt, zwei Halbleiterchips übereinander zu setzen, die nur in diesem Verbund miteinander arbeiten. Jedoch auch eine derartige Maßnahme ist bereits erfolgreich umgangen worden, in dem ein derartiger Chipverbund getrennt wurde, an einem der Chips durch geeignete Maßnahmen Manipulationen vorgenommen wurden, um nach dem Wiederzusammensetzen des Chipverbundes den Betrieb des Chipverbundes aufzunehmen und gewünschte Informationen aus dem betriebenen Chip zu erhalten.

Als vereinfachte Maßnahme werden auch derartige zu schützende Halbleiterchips auf einem Träger aufgebracht, so daß die aktive Fläche des Halbleiterchips, die die zu schützende Information tragende integrierte Schaltung aufweist, von einem Träger abgedeckt ist.

Entsprechend DE10065747A1 ist eine Schaltungsanordnung bekannt, bei der eine zusätzliche Substratschicht mit einer Sensoranordnung ausgebildet ist, die das Vorhandensein des gegenüberliegenden Chips überwacht.

Aus der US 6,380,554 B1 ist eine Anordnung bekannt, in der das gegeneinander ausgerichtete Anordnen zweier rechteckiger leitender Schichten erfasst wird. Die Erfassung wird über eine Widerstandsmessung der Kontaktflächen gegeneinander bestimmt. Darüber hinaus ist aus der US 6,242,757 B1 eine ähnliche Anordnung bekannt, bei der die Erfassung des Überlapp mittels einer Kapazitätsmessung durchgeführt wird.

Es ist folglich Aufgabe der Erfindung einen Halbleiterchip vorzusehen, bei dem für einen sicheren Betrieb feststellbar ist, ob dieser von seinem Träger abgenommen wurde. Weiterhin ist es Aufgabe der Erfindung, eine Chipanordnung vorzusehen, bei der für einen sicheren Betrieb feststellbar ist, ob die Chipanordnung zuvor getrennt wurde. Schließlich ist es Aufgabe der Erfindung, ein Verfahren vorzusehen, mit dem in einem sicheren Betrieb eines Halbleiterchips feststellbar ist, ob dieser aus einer Chipanordnung bzw. von einem Träger zuvor gelöst wurde.

Diese Aufgabe wird erfindungsgemäß mit den in den nebengeordneten Patentansprüchen angegebenen Maßnahmen gelöst.

Dadurch, daß der Abdeckungsgrad einer auf dem Chip vorgesehenen Anschlußfläche, wenn dieser auf einem Träger eine vergleichbare Fläche gegenüberliegend aufweist, feststellbar ist, ist der Chip, von diesem Träger nicht lösbar und wieder identisch aufsetzbar, ohne daß sich der Abdeckungsgrad ändert.

Es ist folglich, nach einem Zusammensetzen wieder feststellbar, ob der Abdeckungsgrad der Anschlußfläche mit dem vorhergehenden bzw. dem vorbestimmten Wert übereinstimmt. Ist eine Abweichung festgestellt, so kann der Betrieb des Chips eingeschränkt oder unterbunden werden.

Vorteilhafte Ausgestaltungen der Erfindung sind in den untergeordneten Ansprüchen angegeben. Hierbei ist es vorteilhaft, wenn auf dem Chip ein ursprünglich initialisierter Wert abgespeichert und zu bestimmten Zeitpunkten mit dem tatsächlich bestimmbaren Wert verglichen wird. Der Wert der Abdeckung ist beispielsweise über eine Widerstandsmessung, jedoch auch mittels kapazitiven oder entsprechenden Messungen möglich.

Besonders vorteilhaft ist es, wenn die Anschlußfläche bzw. die gegenüberliegende eine Abdeckung herstellende Fläche auf dem Träger oder einem anderen Chip in einer Chipanordnung eine derartige Form aufweist, daß bereits minimalste Abweichungen von einer ursprünglichen Abdeckung signifikant meßbar sind. Dies kann beispielsweise durch Figuren mit schrägen oder gekrümmten Kanten erfolgen.

Nachfolgend wird die Erfindung anhand von Ausführungsbeispielen unter Bezugnahme auf die Zeichnung erläutert. Es zeigen:
- Figur 1: eine Chipanordnung,
- Figur 2: ein Ausführungsbeispiel von Anschlußflächen mit unterschiedlichen Abdeckungsgraden
- Figur 3: eine Schaltungsanordnung zur Bestimmung des Abdeckungsgrades,
- Figur 4: ein weiteres Ausführungsbeispiel einer Chipanordnung,
- Figur 5: ein weiteres Ausführungsbeispiel einer Anschlußfläche,
- Figur 6: ein weiteres Ausführungsbeispiel einer Anschlußfläche,
- Figur 7: noch ein weiteres Ausführungsbeispiel zweier gegenüberliegender Anschlußflächen
- Figur 8: ein weiteres Ausführungsbeispiel einer Anschlußfläche
- Figur 9: noch ein Ausführungsbeispiel einer Anschlußfläche.

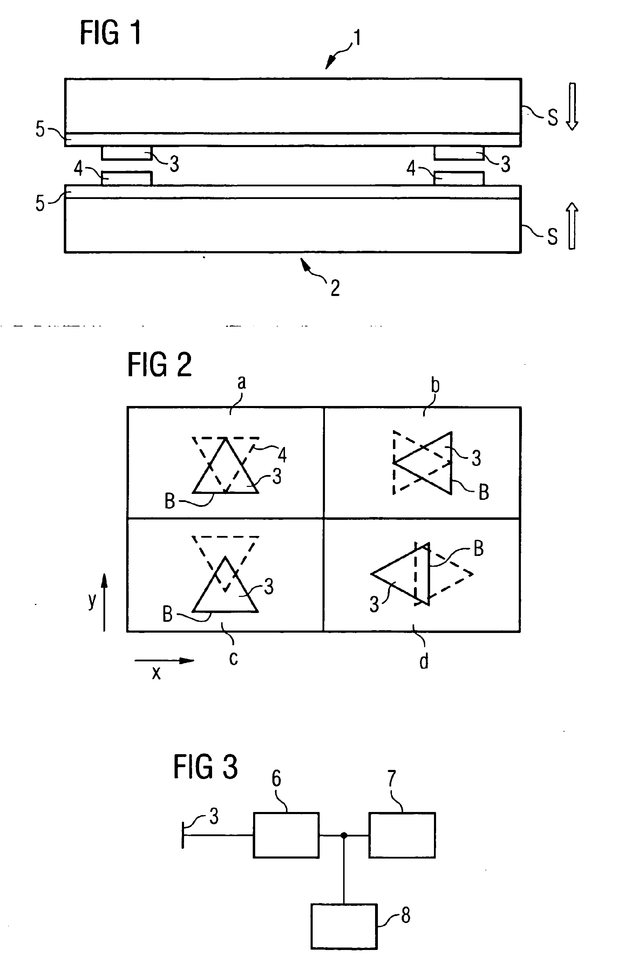

In Figur 1 ist ein erster Halbleiterchip 1 dargestellt, der aus einem Substrat S und einer aktiven Schicht 5 besteht. In dieser aktiven Schicht ist eine mehr oder minder komplexe integrierte Schaltung enthalten, wobei zumindest ein Teil dieser integrierten Schaltung die in Figur 3 dargestellte Schaltungsanordnung aufweist.

In die aktive Schicht 5 eingebettet oder auf diese aufgebracht sind Anschlußflächen 3. Der aktiven Schicht 5 gegenüberliegend ist dem ersten Halbleiterchip 1 ein zweiter Halbleiterchip angeordnet,wobei die beiden Chips in Richtung der rechts dargestellten Pfeile zusammengefügt werden, so daß die Anschlußflächen 3 des ersten Halbleiterchips 1 mit den Anschlußflächen 4 des zweiten Halbleiterchips 2 überlappend zusammengeführt sind.

Je nach Präzision des Zusammenführens und der Genauigkeit der gespiegelten Anordnung der Anschlußflächen, kommt es zu einem mehr oder weniger großen Überlappen der Anschlußflächen. Wird eine derartige Anordnung getrennt und wieder zusammengesetzt, so ist es mit vertretbarem Aufwand unmöglich, den Überlapp der Anschlußflächen zu reproduzieren. Es wird in der Regel immer einen Versatz gegenüber einem vorhergehenden Zustand geben.

Ein solcher Versatz ist in Figur 2 beispielhaft dargestellt. Hier ist mit 3, beispielsweise die Anschlußfläche des ersten Halbleiterchips dargestellt, der eine dreieckige Form aufweist. In diesem Ausführungsbeispiel weist die Anschlußfläche 4 des zweiten Halbleiterchips ebenfalls eine dreieckige Form auf, wie gestrichelt dargestellt ist, wobei wenn es sich um ein gleichschenkliges Dreieck handelt, die Spitze auf die Basis B des jeweiligen anderen Dreiecks gerichtet sind.

Im Feld a liegt die Spitze des gleichschenkeligen Dreiecks jeweils auf der Basis des anderen Dreiecks. Ein Versatz in y-Richtung führt dann zu einem Verschieben mit signifikanten Überlappungsänderungen, wie im Ausschnitt c in Figur 2 dargestellt ist. Entsprechendes gilt gemäß der Ausschnitte b und d bei einem Versatz in x-Richtung.

Der Figur 2 kann man entnehmen, daß bereits mit einer Anschlußfläche ein Versatz feststellbar ist. Bei genauer Betrachtung wird jedoch leicht klar, daß bei einem Versatz in zwei Richtungen das Ausmaß der Überlappung zumindest innerhalb bestimmter Grenzen des Versatzes gleich bleiben kann. Aus diesem Grunde ist es vorteilhaft, wenn, wie in Figur 2 dargestellt ist, zwei Anschlußflächen auf dem Chip vorgesehen sind, die nicht identisch ausgerichtet sind. Gemäß Figur 2 ist die Basis B des Dreiecks im Ausschnitt b um 90 Grad gegenüber der Basis B im Ausschnitt a gedreht.

Die Überlappung kann nunmehr mit einer Meßschaltung, wie sie in Figur 3 dargestellt ist, festgestellt werden. Mit der Anschlußfläche 3 ist eine Meßeinrichtung 6 verbunden, die eine Widerstandsmessung durchführt, wenn eine leitende Verbindung zwischen der Anschlußfläche 3 und einer gegenüberliegenden in Überlapp gebrachten Fläche vorhanden ist. Es ist jedoch genauso gut möglich, daß die Meßeinrichtung 6 einen Kapazitätswert ermittelt, wenn es zu keiner leitenden Verbindung kommt.

Im Ausführungsbeispiel gemäß Figur 3 ist eine Verarbeitungseinrichtung 8 vorgesehen. Diese liest nach einem ersten Zusammensetzen des Halbleiterchips in einer Chipanordnung oder auf einem Träger den mit der Meßeinrichtung gemessenen und einem Überlapp zugeordneten Wert aus und speichert ihn in einer Speichereinrichtung 7. Während des weiteren Betriebs des Halbleiterchips 1, beispielsweise bei jeder erneuten Inbetriebnahme oder auch während des laufenden Betriebes, wird von der Meßeinrichtung 6 erneut der einer Überlappung entsprechende Wert von der Verarbeitungseinrichtung ausgelesen und mit dem in der Speichereinrichtung 7 gespeicherten Wert verglichen. Sind diese beiden Werte nicht identisch, so muß sich der Überlapp an der Anschlußfläche 3 verändert haben. Dies kann nur dadurch erfolgt sein, daß der Halbleiterchip von seinem Träger getrennt wurde.

Mit Träger sei in diesem Zusammenhang zum Einen gemeint, daß es ein baugleicher oder ähnlicher Halbleiterchip ist oder ein anderes Trägermaterial, das eine Fläche aufweist, die mit der Anschlußfläche 3 des Halbleiterchips in Überlapp gebracht wurde und die bei einem Versatz zu einer signifikanten Änderung des Überlapps führt.

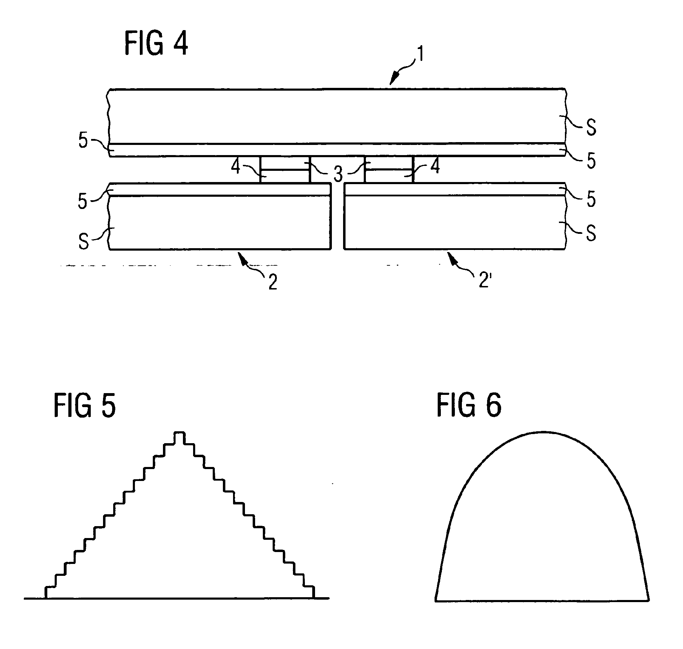

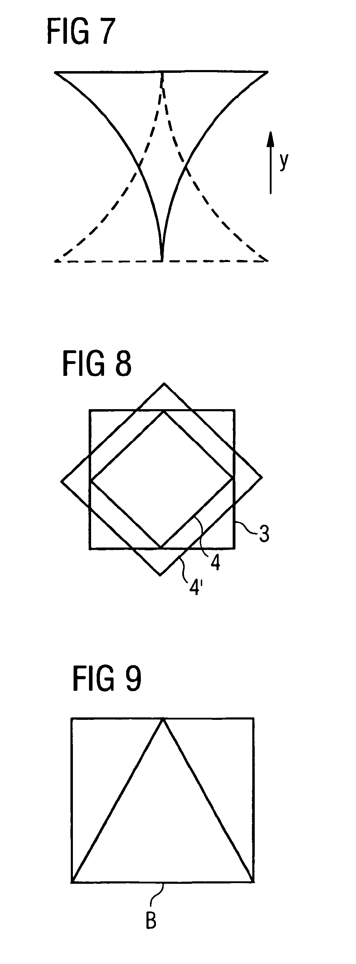

An dieser Stelle sei ein zuvor bereits angesprochenes Problem unter Bezugnahme von Figur 8 aufgegriffen. Hier sieht man eine quadratische Anschlußfläche 3. Dieser ist in Rautenform eine Anschlußfläche 4' in Überlapp gebracht. Man erkennt, daß hier ein Versatz des Halbleiterchips gegenüber seinem Träger innerhalb bestimmter Grenzen zu einem gleichbleibenden Überlapp führen kann. Weist jedoch die gegenüberliegende Fläche die Form 4 auf, so ist zu sehen, daß bereits ein Verschieben minimalster Form in eine der Richtungen zu einer eindeutigen Änderung des Wertes des Überlappes führt. In den Figuren 5, 6, 7 und 9 sind weitere Ausführungsbeispiele der Anschlußfläche 3 bzw. 4 dargestellt. Diese können auch miteinander kombiniert werden, wie dies beispielsweise in Figur 9 zu sehen ist.

Bei einem Ausführungsbeispiel, wie es in Figur 7 dargestellt ist, sollte der gekrümmte Kantenverlauf der Anschlußflächen zu einer Veränderung des Überlappwertes führen, die nichtlinear zum Versatz ist.

Ein weiteres Ausführungsbeispiel einer Chipanordnung ist in Figur 4 dargestellt. Hierbei liegen zwei Halbleiterchips 2 und 2' nebeneinander, wobei der erste Halbleiterchip 1 beide Halbleiterchips miteinander verbindet. Es ist leicht einzusehen, daß darüber hinaus durch Kombination der dargestellten Ausführungsbeispiele durch Ergänzung und Vervielfachung einzelner Elemente bei Beibehaltung des Erfindungsgedankens möglich ist.

Die zuvor beschriebene Erfindung ist in vielfältiger Weise verwendbar.

Zum Einen ist der gespeicherte Wert, der dem Überlapp entspricht als sogenanntes Wasserzeichen verwendbar. Dies bedeutet, es kann als individuelles Kennzeichen oder auch als Grundlage für die Erzeugung eines Schlüssels für einen Datenaustausch nach außerhalb der Anordnung verwendet werden.

Weiterhin kann die Erfindung auch für Qualitätskontrollen eingesetzt werden. In diesem Fall kann die Anordnung durch Vergleich mit einem zuvor auf zumindest einem der Chips gespeicherten vorgegebenen Wert ermitteln, ob die Ausrichtung des Chips gegenüber dem Träger ausreichend genau ist. Liegt der Wert außerhalb vorgegebener Grenzen, so ist es möglich, daß die Anordnung selbstätig ihren Betrieb verweigert.

Entsprechend kann auch der in der Speichereinrichtung ursprünglich gespeicherte Wert bei der Herstellung von außerhalb überprüft werden und zur Qualitätsprüfung verwendet werden.

### Bezugszeichenliste

- 1: erster Chip
- 2: zweiter Chip
- S: Substrat
- 3: Anschlußfläche, Pad
- 4: Anschlußfläche, Pad
- 5: aktive Schicht
- 6: Meßeinrichtung
- 7: Speichereinrichtung
- 8: Verarbeitungseinrichtung, Vergleichseinrichtung

## Patentansprüche

1. Halbleiterchip mit einer aktiven Schicht (5), die von einem Substrat(S) getragen wird und zumindest einer Anschlussfläche(3), wobei die aktive Schicht (5) eine Detektoreinrichtung (6,7,8) aufweist, mit der ein Abdeckungsgrad der zumindest einen Anschlussfläche (3), bestimmbar ist, **dadurch gekennzeichnet, daß** die Anschlüßfläche mindestens eine gekrümmte und/oder schräge Kante aufweist.

2. Halbleiterchip nach Anspruch 1, bei dem
die Detektoreinrichtung mittels einer Meßeinrichtung(6)einen Abdeckungsgrad der zumindest einen Anschlussfläche (3) bestimmt und mittels einer Vergleichseinrichtung (8) mit einem in einer Speichereinrichtung (7) gespeicherten vorgestimmten Wert vergleicht.

3. Halbleiterchip nach Anspruch 2, bei dem
die Anschlussfläche (3) dreieckförmig ist.

4. Halbleiterchip nach Anspruch 3, bei dem
die Anschlussfläche (3) rautenförmig ist.

5. Halbleiterchip nach Anspruch 3, bei dem
zumindest zwei Anschlussflächen (3) als gleichschenklige Dreiecke vorgesehen sind, deren jeweilige Basen (b) zueinander nicht parallel ausgerichtet sind.

6. Halbleiterchip nach Anspruch 1, bei dem
das Abdeckungsausmaß mittels Widerstandsmessung feststellbar ist.

7. Halbleiterchip nach Anspruch 1, bei dem das Abdeckungsausmaß mittels Kapazitätsmessung feststellbar ist.

8. Halbleiterchip nach Anspruch 1, bei dem die Anschlussfläche (3) zum zusätzlichen Übertragen von Daten und/oder Energie vorgesehen ist.

9. Chipanordnung mit zumindest zwei Halbleiterchips (1,2) wobei zumindest einer der zumindest zwei Halbleiterchips nach einem der Patentansprüche 1 bis 7 ausgebildet ist, wobei dessen Anschlussfläche (3) einer Anschlussfläche (4) des zumindest einen anderen Chips (2) gegenübersteht und sich die Anschlussflächen (3, 4) zumindest teilweise überlappen, wobei eine Änderung des Versatzes der Anschlussflächen (3, 4) zu einer dem Versatz überproportionalen Änderung des Abdeckungsgrades führt.

10. Chipanordnung nach Anspruch 9, wobei
die zumindest zwei Halbleiterchips (1,2) nach einem der Patentansprüche 1 bis 7 ausgebildet sind.

11. Verfahren zum Überprüfen der Ausrichtung zumindest zweier übereinanderliegender Halbleiterchips in einer Chipanordnung gemäß Patentanspruch 9 oder 10, wobei eine Änderung der gegenseitigen Ausrichtung der zumindest zwei Halbleiterchips (1, 2) zueinander durch ein Bestimmen der Änderung des überproportionalen Überlappungsausmaßes der gegenüberliegenden Anschlussflächen (3,4) ermittelt wird.

12. Verfahren nach Anspruch 11, bei dem
der Wert der Überlappung der gegenüberliegenden Anschlussflächen mit einem abgespeicherten Wert verglichen wird.

13. Verfahren nach Anspruch 12, bei dem
in einem der zumindest zwei Halbleiterchips ein Signal erzeugt wird, wenn eine Abweichung zwischen dem ermittelten Wert und dem vorbestimmten Wert feststellbar ist.

14. Verfahren nach Anspruch 13, bei dem
bei der ersten Inbetriebnahme der Chipanordnung das Ausmaß der Überlappung der Anschlussflächen bestimmt wird und als vorbestimmter Wert in zumindest einem der zumindest zwei Halbleiterchips abgespeichert wird.

## Claims

1. Semiconductor chip having an active layer (5), which is carried by a substrate (S) and has at least one connection pad (3), the active layer (5) having a detector device (6, 7, 8) which can be used to determine a degree of coverage of the at least one connection pad (3), **characterized in that** the connection pad has at least one curved and/or oblique edge.

2. Semiconductor chip according to Claim 1, wherein the detector device determines a degree of coverage of the at least one connection pad (3) by means of a measuring device (6) and compares it with a predetermined value stored in a memory device (7) by means of a comparison device (8).

3. Semiconductor chip according to Claim 2, wherein the connection pad (3) is triangular.

4. Semiconductor chip according to Claim 3, wherein the connection pad (3) is rhomboidal.

5. Semiconductor chip according to Claim 3, wherein at least two connection pads (3) are provided as isosceles triangles whose respective bases (b) are not aligned parallel to one another.

6. Semiconductor chip according to Claim 1, wherein the extent of coverage can be ascertained by means of resistance measurement.

7. Semiconductor chip according to Claim 1, wherein the extent of coverage can be ascertained by means of capacitance measurement.

8. Semiconductor chip according to Claim 1, wherein the connection pad (3) is provided for additionally transmitting data and/or energy.

9. Chip assembly comprising at least two semiconductor chips (1, 2), wherein at least one of the at least two semiconductor chips is embodied according to any of Patent Claims 1 to 7, wherein the connection pad (3) of said at least one chip is opposite a connection pad (4) of the at least one other chip (2) and the connection pads (3, 4) at least partly overlap, wherein a change in the offset of the connection pads (3, 4) leads to a change in the degree of coverage which is more than proportional to the offset.

10. Chip assembly according to Claim 9, wherein the at least two semiconductor chips (1, 2) are embodied according to any one of Patent Claims 1 to 7.

11. Method for checking the alignment of at least two semiconductor chips lying one above another in a chip assembly according to Patent Claim 9 or 10, wherein a change in the mutual alignment of the at least two semiconductor chips (1, 2) with respect to one another is determined by determining the change in the more than proportional extent of overlap of the opposite connection pads (3, 4).

12. Method according to Claim 11, wherein the value of the overlap of the opposite connection pads is compared with a stored value.

13. Method according to Claim 12, wherein a signal is generated in one of the at least two semiconductor chips if a deviation between the value determined and the predetermined value can be ascertained.

14. Method according to Claim 13, wherein when the chip assembly is first started up, the extent of the overlap of the connection pads is determined and is stored as predetermined value in at least one of the at least two semiconductor chips.

## Revendications

1. Puce à semi-conducteur ayant une couche (5) active qui est portée par un substrat (S) et au moins une surface (3) de borne, la couche (5) active ayant un dispositif (6, 7, 8) formant détecteur, par lequel un degré de recouvrement de la au moins une surface (3) de borne peut être déterminé, **caractérisée en ce que** la surface de borne a au moins un bord courbé et/ou incliné.

2. Puce à semi-conducteur suivant la revendication 1, dans laquelle
le dispositif formant détecteur détermine un degré de recouvrement de la au moins une surface (3) de borne au moyen d'un dispositif (6) de mesure et le compare au moyen d'un dispositif (8) de comparaison à une valeur déterminée à l'avance et mémorisée dans un dispositif (7) de mémoire.

3. Puce à semi-conducteur suivant la revendication 2, dans laquelle
la surface (3) de borne est triangulaire.

4. Puce à semi-conducteur suivant la revendication 3, dans laquelle
la surface (3) de borne est en forme de losange.

5. Puce à semi-conducteur suivant la revendication 3, dans laquelle
il est prévu au moins deux surfaces (3) de borne sous forme de triangles isocèles dont les bases (b) respectives ne sont pas parallèles entres elles.

6. Puce à semi-conducteur suivant la revendication 1, dans laquelle
l'étendue du recouvrement peut être constatée au moyen d'une mesure de résistance.

7. Puce à semi-conducteur suivant la revendication 1, dans laquelle
l'étendue du recouvrement peut être constatée au moyen d'une mesure de capacité.

8. Puce à semi-conducteur suivant la revendication 1, dans laquelle
la surface (3) de borne est prévue pour la transmission supplémentaire de données et/ou d'énergie.

9. Dispositif de puces ayant au moins deux puces (1, 2) à semi-conducteur, au moins l'une des au moins deux puces à semi-conducteur étant constituée suivant l'une des revendications 1 à 7, dans lequel sa surface (3) de borne est opposée à une surface (4) de borne de la au moins une autre puce (2) et les surfaces (3, 4) de borne se chevauchent au moins en partie, une modification du décalage des surfaces (3, 4) de borne provoquant une modification de la désadaptation des surfaces (3, 4) de borne provoquant une modification du degré de recouvrement plus que proportionnelle à la désadaptation.

10. Dispositif de puces suivant la revendication 9, dans lequel
les au moins deux puces (1, 2) à semi-conducteur sont constituées selon l'une des revendications 1 à 7.

11. Procédé de contrôle de l'alignement d'au moins deux puces à semi-conducteur superposées d'un dispositif à puce suivant la revendication 9 ou 10, une modification de l'alignement mutuel des au moins deux puces (1, 2) à semi-conducteur l'une par rapport à l'autre étant déterminée par une détermination de la modification de l'étendue de chevauchement plus que proportionnelle des surfaces (3, 4) de borne opposées.

12. Procédé suivant la revendication 11, dans lequel
on compare la valeur du chevauchement des surfaces de borne opposées à une valeur mémorisée.

13. Procédé suivant la revendication 12, dans lequel
on produit un signal dans l'une des au moins deux puces à semi-conducteur lorsque l'on peut constater un écart entre la valeur déterminée et la valeur prescrite.

14. Procédé suivant la revendication 13, dans lequel lors de la première mise en fonctionnement du dispositif de puce, on détermine l'étendue du chevauchement des surfaces de borne et on la mémorise en tant que valeur prescrite dans au moins l'une des au moins deux puces à semi-conducteur.
